# EUROPÄISCHE PATENTSCHRIFT

(11) **EP 0 328 048 B1**
(45) Veröffentlichungstag und Bekanntmachung des Hinweises auf die Patenterteilung: **04.06.1997**
(21) Anmeldenummer: 89102106.5
(22) Anmeldetag: 08.02.1989
(51) Int. Cl.: H01L 21/322, H01L 21/324

(54) **Herstellung von Halbleiterscheiben mit verbesserter Kontrolle der Innenstörstellen**
Method of producing semiconductor wafers with a modified check of the inner imperfections
Procédé pour fabriquer un disque semi-conducteur avec un contrôle modifié des imperfections internes

(30) Priorität: 11.02.1988 US 154759
(43) Veröffentlichungstag der Anmeldung: 16.08.1989
(73) Patentinhaber: MEMC Electronic Materials, Inc., St. Peters, Missouri 63376 (US)
(72) Erfinder: Huber, Walter, Dr., I-20154 Milano (IT)
(74) Vertreter: Maiwald, Walter, Dr. Dipl.-Chem.

(56) Entgegenhaltungen:
- EP-A- 0 060 676
- US-A- 4 314 595
- US-A- 4 432 809
- US-A- 4 622 082
- US-A- 4 666 532
- SOLID STATE TECHNOLOGY, Band 24, Nr. 7, Juli 1981, Seiten 55-61, Port Washington, New York, US; R.A. CRAVEN et al.: "Internal gettering in silicon"

## Beschreibung

Die vorliegende Erfindung bezieht sich ganz allgemein auf die Herstellung von Halbleiterscheibenmaterial. Insbesondere bezieht sich die Erfindung auf die Herstellung von Siliziumscheibenmaterial unter Bedingungen, die die Konzentration von Innenstörstellen steuern.

Einkristall-Silizium, das Ausgangsmaterial für die meisten Halbleiterherstellungsverfahren, wird meistens nach der CZOCHRALSKI-Methode hergestellt, wo ein einzelner Kristallkeim in geschmolzenes Silizium getaucht und langsam wieder herausgezogen wird. Durch Drehen des Kristalls wird ein zylindrischer Block hergestellt, der einen gewünschten Durchmesser aufweist. Das geschmolzene Silizium wird in einem Quarztiegel gehalten.

Obgleich charakterisiert durch sehr hohe Reinheit, weisen die Siliziumkristalle, die nach der CZOCHRALSKI-Methode hergestellt werden, doch einen gewissen Grad an Verunreinigungen auf. Vor allem ist Sauerstoff, der aus dem Quarztiegel kommt, in Konzentrationen von ca. 10 bis 20 ppma vorhanden. Derartige Konzentrationen liegen über der festen Löslichkeit bei Temperaturen, die typisch für die Herstellungsverfahren von integrierten Schaltkreisen sind. Da sie sich in übersättigter Lösung befinden, neigen die Sauerstoffatome dazu, sich auszuscheiden. Das Ausscheiden von Sauerstoff liefert Haftstellen für Verunreinigungen, die bzgl. der Wirksamkeit von integrierten Schaltkreisen schädlich sind. Diese Technik, Verunreinigungen aus der Nähe der aktiven Scheibenoberfläche durch Sauerstoffausscheidung zu entfernen, wird nachstehend als "Innenstörstellen" bezeichnet.

Bisher waren die Vorteile, die mit den Störstellen verbunden sind, die durch das Einlagern von Sauerstoffgruppen im Innern entstanden sind, nicht vorhersehbar. Obwohl die Ausgangskonzentration von gelöstem Sauerstoff in Siliziumkristallen gesteuert werden kann, so hängt doch die Konzentration von Störstellen, die durch die nachfolgende Wärmebehandlung der einzelnen Scheiben erzeugt werden kann, von einer Anzahl von Faktoren ab und variiert sehr. Während die optimale Konzentration von Störstellen für eine spezielle Anwendungsart bekannt sein mag, so kann doch die tatsächliche Konzentration, die in einer Scheibe vorhanden ist, die bearbeitet wird, nur sehr schwer auf eine bestimmte Konzentration eingestellt werden.

Aus diesem Grunde wäre es wünschenswert, Methoden zur Steuerung der Konzentration der Störstellen, die in Halbleitermaterialien vorhanden sind, zur Verfügung zu haben. Insbesondere wäre es wünschenswert, Methoden vorzusehen, bei denen die Konzentration von Sauerstoffausscheidungssstellen in Siliziummaterialien, die nach dem CZOCHRALSKI-Verfahren und anderen herkömmlichen Silizium-Herstellungsmethoden hergetellt werden, gesteuert werden kann.

HAWKINS and LAVINE (1987) MATERIALS RESEARCH SOCIETY MTG., Nov. 30-Dec. 5, zeigen einen mutmaßlichen heterogenen Keimbildungsmechanismus für Sauerstoff in Silizium, indem man eine Scheibe zunächst einem schnellen Temperverfahren unterzieht, dem ein Erhitzen bei 950°C für eine Stunde und bei 1200°C für 13 Stunden folgt. Es zeigt sich keine Optimierung der Innenstörstellenkonzentration.
ALVI u.a. (1987) ELECTROCHEMICAL SOCIETY MTG., Oct. 18-23, beschreiben die Auswirkung von schnellem Tempern auf die Auflösung der metallischen Einlagerungen in Siliziumscheiben.
HAHN u.a. (1986) MATERIAL RESEARCH SOCIETY SYMP. PROC. 59:287-292 beschreiben die Bildung von thermischen Donatoren durch Erhitzen von Siliziumscheiben bei 450°C, dem ein schnelles Erhitzen zwischen 600°C bis 1000°C folgt, gefolgt von einem weiteren zweistufigen Erhitzen im Ofen bei 700°C und 950°C. Das Schriftstück geht nicht auf das Erfordernis der Wiederherstellung einer gewünschten Konzentration von Sauerstoffeinlagerungen ein.
CHANG-OUTU AND TOBIN (1986) J. ELECTROCHEM. SOC. 133:2147-2152 meint, daß das Ausscheiden von Sauerstoff bei den Scheibenherstellungsverfahren sehr stark von der Ausgangskonzentration des gelösten Sauerstoffs im Silizium abhängt. Eine Ausgangssauerstoffkonzentration im Bereich von ungefähr 14 bis 16 ppma wird für den nachfolgenden Einfang von Verunreinigungen durch Störstellen als optimal angesehen.
JASTRZEBSKI u.a. (1984) J. ELECTROCHEM. SOC. 131:2944-2953 lehren eine Wechselbeziehung zwischen der Menge des eingelagerten Sauerstoffs und den speziellen Gegebenheiten der Siliziumscheibenherstellung.
INOUE u.a. (1981) lehrt in "Semiconductor Silicon 1981", Ausgabe HUFF u.a., Proc. , Band 81-5, The Electrochemical Society, Seiten 282-293, daß die Konzentration von Sauerstoffeinlagerungen in einer Siliziumscheibe durch Erhitzen bei niedrigen Temperaturen erhöht werden kann. Schließlich bezieht sich das U.S. Patent Nr. 4,608,095 auf äußere Störstellen, indem es eine Polysiliziumschicht auf der hinteren Oberfläche der Scheibe vorsieht.

Die US-A-4,622,082 betrifft ein Verfahren zur thermischen Nachbehandlung von sauerstoffhaltigen Halbleitermaterialien vom n+-Typ. Das Verfahren besteht aus wenigstens zwei Schritten, wobei in dem ersten Schritt das Halbleitermaterial in einer oxidierenden Atmosphäre auf eine Temperatur von 1050°C bis 1200°C erhitzt wird. Anschließend wird das Halbleitermaterial für eine vorbestimmte Zeit bei einer Temperatur von 500°C bis 900°C einer reduzierenden Atmosphäre ausgesetzt. Optional kann das Material in einem dritten Schritt über eine vorbestimmte Zeit in einer Inertatmosphäre bei einer Temperatur von 900°C bis 1150°C nachbehandelt werden.

Die EP-A-0 060 676 beschreibt ein Verfahren zur Herstellung eines Halbleitermaterials, das einen intrinsischen Gettereffekt aufweist. Das Verfahren umfaßt ein zweistufiges Ausheizen eines Siliciumwafers, bei dem der Siliciumwafer im ersten Schritt auf eine Temperatur im Bereich vom 500°C bis 900°C erhitzt wird und anschließend die Temperatur in einem zweiten Schritt auf den Bereich von 950°C bis 1300°C erhöht wird. Das Erwärmen von der ersten Temperatur auf die zweite Temperatur geschieht dabei mit einer Geschwindigkeit von nicht mehr als 14°C pro Minute.

Gemäß der vorliegenden Erfindung werden Methoden vorgesehen, um die Konzentration von Innenstörstellen, wie z.B. Sauerstoffgruppen, in einem Halbleitermaterial zu steuern. Die Methoden beruhen auf einem Zweistufenverfahren, wo die Konzentration von Störstellen zunächst erst einmal wesentlich erhöht oder wesentlich verringert wird. Durch Erhöhen der Störstellenkonzentration über den gewünschten Optimalwert kann die Konzentration dann auf den gewünschten Optimalwert durch schnelles Erhitzen bei besonderer Temperatur oder in einem besonderen Temperaturbereich für einen im voraus ausgewählten Zeitraum reduziert werden. Auf der anderen Seite kann man durch anfängliches Reduzieren der Konzentration der Innenstörstellen unter den gewünschten Optimalwert die Konzentration - durch Erhitzen bei relativ niedrigen Temperaturen für einen bestimmten Zeitraum - erhöhen. Auf diese Art und Weise ist die Endkonzentration der Innenstörstellen weder von der Ausgangsverunreinigungskonzention noch von der Bearbeitungsgeschichte des Halbleiterscheibenkristalls abhängig.

In der beispielhaften Darstellung wird das Siliziumscheibenmaterial zunächst schnell auf eine erhöhte Temperatur im Bereich von ca. 900 bis 1300°C erhitzt, vorzugsweise auf ca. 1000 bis 1250°C. Die Erhitzungsgeschwindigkeit beträgt im allgemeinen mindestens ca. 10°C pro Sekunde, vorzugsweise mindestens ca. 100°C pro Sekunde, wobei das Scheibenmaterial mindestens ca. 1 Sekunde lang bei erhöhter Temperatur, im allgemeinen für einen Zeitraum von mindestens ungefähr 5 Sekunden, was von der genauen Temperatur abhängt, auf die die Scheibe erhitzt wurde, gehalten wird. Ein solch schnelles Erhitzen des Siliziummaterials wurde als notwendig erachtet, um wesentlich die Konzentration der relativ kleinen Sauerstoffgruppen (d.h. solche, die in der Lage sind, zu Störstellen zu wachsen), im Siliziumscheibenmaterial zu reduzieren. Im allgemeinen wird die Konzentration von kleinen Sauerstoffgruppen ausreichend reduziert, um eine Innenstörstellenkonzentration von unter ca. 10⁶/cm² zu erreichen, die oft auf weniger als 10⁵/cm² reduziert wird und gelegentlich auf weniger als ca. 10⁴/cm².

Nach der Ausgangsreduzierung kann die Konzentration der relativ kleinen Sauerstoffgruppen auf einen gewünschten optimalen Stand erhöht werden, indem die Substrate bei relativ niedriger Temperatur, typisch im Bereich von ca. 550 bis 850°C, noch typischer im Bereich von ca. 600 bis 750°C, für einen relativ langen Zeitraum, typisch im Bereich zwischen ca. 15 and 360 Minuten, erhitzt werden, üblicherweise 1 bis 4 Stunden lang. Die genaue Zeit und Temperatur des Erhitzens wird gewählt, um die optimale Störstellenkonzentration zu erhalten, die üblicherweise im Bereich von ca. 10⁵ bis 5x10⁶/cm², noch üblicher im Bereich von ca. 2x10⁵ bis 10⁶/cm², liegt.

Nachdem die Scheiben dem Verfahren gemäß der vorliegenden Erfindung unterzogen wurden, sind sie bereit für die herkömmlichen Herstellungsverfahren, wo aktive Bereiche auf der oberen Oberfläche derselben gebildet werden. Während solch herkömmlicher Verfahren werden die Verunreinigungen innerhalb der Halbleiterscheibe in die Sauerstoffgruppe an den Störstellen und weg von der aktiven Oberfläche der Scheibe gezogen.

Die vorliegende Erfindung ist eine Methode zur Kontrolle der Konzentration von Innenstörstellen in Halbleitermaterial, das für die Herstellung von integrierten Schaltkreisen verwendet wird. Innenstörstellen entwickeln sich aus dem Zusammenballen gewisser Verunreinigungen heraus zu Gruppen, die eine kritische Masse haben. Derartige Anhäufungen ziehen andere schädliche Verunreinigungen während der nachfolgenden thermischen Bearbeitung der Halbleiterscheiben an sich. Durch Wegziehen solch schädlicher Verunreinigungen von der aktiven Oberfläche des Materials können die Ausbeute an integrierten Schaltkreisen und die Leistung sehr verbessert werden.

Ohne Vorbehandlung der Scheiben kann die Konzentration der Innenstörstellen sehr variieren, typischerweise innerhalb eines Bereiches von ungefähr 10⁴ bis 10⁷ Stellen /cm². Es ist wünschenswert, daß die Konzentration solcher Stellen zu Beginn der normalen Scheibenherstellungsverfahren im Bereich von ungefähr 10⁵ bis 5 x 10⁶ Stellen/cm² liegt, vorzugsweise im Bereich von ca. 2x10⁵ bis 10⁶ Stellen/cm².

Die Steuerung der Konzentration der Innenstörstellen erfolgt, indem man die Scheibe in einem Zweistufenverfahren, das beides umfaßt - eine Konzentrationsreduktionsphase und eine Konzentrationssteigerungsphase für die Verunreinigungsanhäufung - vorbehandelt. Indem man zunächst mit der Konzentrationsreduktionsphase beginnt, wird die Konzentration der Verunreinigungsanhäufungen mit kritischer Masse unter den gewünschten Stand gebracht. Der gewünschte Stand kann dann erreicht werden, indem man die Konzentrationssteigerungsphase unter im voraus gewählten Bedingungen durchführt für einen Zeitraum, der so gewählt wird, daß man die genaue gewünschte Konzentration erhält. Umgekehrt ist es so, daß, wenn man mit der Konzentrationssteigerungsphase beginnt, die Konzentration der Verunreinigungsanhäufungen mit kritischer Masse über den gewünschten Stand erhöht werden kann. Die gewünschte Konzentration kann dann dadurch erhalten werden, daß man die Konzentrationsreduktionsphase unter Bedingungen und für einen Zeitraum durchführt, die so gewählt werden, daß der gewünschte Stand erreicht wird.

Die Methode nach der vorliegenden Erfindung wird dazu benutzt, die Konzentration der Innenstörstellen in Einkristall-Halbleiterscheiben, die bei der Herstellung von integrierten Schaltkreisen für die elektronische Industrie verwendet werden, zu steuern. Während normalerweise Silizium als Scheibenmaterial gewählt wird, können auch andere Halbleitermaterialien, wie z.B. Galliumarsenid, Indiumphosphid, Galliumaluminiumarsenid, Germanium, Siliziumkarbid, Indiumantimonid und dgl. (ganz allgemein als III-V-Verbindung-Halbleiter bezeichnet) Verwendung finden. Die Halbleitermaterialien können jede herkömmliche Kristallgitterorientierung und alle spezifischen Widerstände aufweisen und die herkömmlichen Abmessungen haben, wie sie bei der Herstellung in der Scheibenindustrie Verwendung finden.

Die Halbleitermaterialien, die eingesetzt werden, haben Verunreinigungen, sowohl auscheidbare Verunreinigungen, die sich in Anhäufungen zusammenballen und als Störstellen reagieren, als auch schädliche Verunreinigungen, die im allgemeinen metallische Verunreinigungen sind, die von der aktiven Oberfläche des Halbleitermaterials durch Störstellen entfernt werden können. Es ist wünschenswert, daß die Verunreinigungen im wesentlichen von einer 1 bis 50 Mikron dicken Schicht, unmittelbar unterhalb der aktiven Oberfläche, typischerweise von einer 10 bis 30 Mikrometer (Mikron) dicken Schicht, unmittelbar unterhalb der aktiven Oberfläche, entfernt werden.
Die einlagerbaren Verunreinigungen enthalten mobile Atome, die in der Lage sind, sich in Anhäufungen zusammenzuballen, welche eine empirisch abgeleitete kritische Masse unter den hier spezifizierten Bearbeitungsbedingungen aufweisen. Im allgemeinen sind die ausscheidbaren Verunreinigungen, die im Halbleitermaterial vorhanden sind, das Ergebnis des ersten Kristallwachstumsverfahrens, obgleich es in einigen Fällen nötig oder wünschenswert sein mag, absichtlich Verunreinigungen während des Wachstumsverfahrens einzuführen. In Siliziumhalbleiterkristallen, die nach dem CZOCHRALSKI-Verfahren hergestellt werden, besteht die ausscheidbare Verunreinigung normalerweise aus Sauerstoffatomen, die aus der Quarztiegeleinlage stammen, die das geschmolzene Silizium enthält, aus dem die Kristalle gezogen werden. Der Sauerstoff ist im allgemeinen in einer Konzentration vorhanden, die nahe der Löslichkeitsgrenze liegt, typischerweise im Bereich zwischen ca. 10 und 20 ppma (Teile pro Million Atombasis gemessen nach ASTM F121-83), im allgemeinem im Bereich zwischen 12 bis 18 ppma. Andere Verunreinigungen und Fehler, wie z.B. Stickstoff, Kohlenstoff, natürliche Fehler im Silizium und dgl. können während der Kristallwachstumsphase hinzugefügt werden, wenn es wünschenswert ist, die Konzentration der ausscheidbaren Verunreinigungen zu erhöhen.

Wenn der Siliziumkristall durch das Fließzonen-Verfahren hergestellt wird, so müssen die ausscheidbaren Verunreinigungen absichtlich hinzugefügt werden. Ausscheidbare Verunreinigungen, wie
z.B. Stickstoff, Sauerstoff, Kohlenstoff und dgl., können verwendet werden. Zweckmäßigerweise ist die ausscheidbare Verunreinigung Stickstoff, der durch Kristallwachstum in einer Stickstoff enthaltenden Umgebung in einer Konzentration im Bereich von ca. 0.1 bis 10 ppma eingeführt wird. Das Halbleitermaterial, das nach beidem - dem CZOCHRALSKI-Verfahren und dem Fließzonenverfahren - hergestellt wird, hat die Form von großen zylindrischen Blöcken, die in einzelne Scheiben geschnitten werden, die eine typische Dicke im Bereich von ca. 25,4 bis 127 Mikrometer (10 bis 50 mils), typischer im Bereich von ca. 38,1 bis 68,6 Mikrometer (15 bis 27 mils), aufweisen. Die Scheiben werden mittels Diamantsägen geschnitten und können nach der Methode der vorliegenden Erfindung entweder direkt nach dem Schneiden oder nach weiteren Verfahrensstufen behandelt werden. Derartige weitere Verfahrensstufen schließen das Läppen mit ein, um Unregelmäßigkeiten, die durch das Schneiden und Polieren zwecks Bildung einer Oberfläche mit optischer Qualität verursacht wurden, zu entfernen. Zusätzlich können die Scheiben mit dünnen Schichten überzogen werden, einschließlich Oxiden, Nitriden, Polysilizium-Schichten und dgl. Alle Schichten, die vor der Bearbeitung gemäß dieser Erfindung aufgebracht wurden, müssen den Bearbeitungsbedingungen, die nachfolgend dargelegt sind, widerstehen können.

Die schädlichen Verunreinigungen, die durch die Störstellen in den Scheiben angezogen werden, enthalten in erster Linie Metallarten wie Eisen, Nickel, Kupfer, Titan und dgl. Die Verunreinigungen sammeln sich an den Störstellen während der üblichen thermischen Bearbeitung der Scheiben, die für die Herstellung integrierter Schaltkreise eingesetzt werden.

Die Innenstörstellen sind Gruppen von ausscheidbaren Verunreinigungen, typischerweise Sauerstoff oder Stickstoff, die eine kritische Masse oder Anzahl von Atomen haben, die ausreichend groß ist, so daß die Stellen die Verunreinigungen während der folgenden thermischen Bearbeitung der Scheibe anziehen. Die genaue Masse variiert, was sowohl von der Art des Halbleitermaterials als auch der Art der ausscheidbaren Verunreinigung abhängt. Verfahrensmäßig gesehen können Störstellen als Anhäufungen definiert werden, die in der Lage sind, schädliche Verunreinigungen unter thermischen Bearbeitungsbedingungen, wie sie bei der Halbleiter-Herstellung eingesetzt werden, anzuziehen und die typischerweise im Temperaturbereich von ungefähr 400 bis 1250° C, insbesondere im Bereich von ungefähr 800 bis 1150°C, liegen. Unbehandelte Scheiben werden im allgemeinen eine Verteilung von ausscheidbaren Verunreinigungsanhäufungsgrößen haben, wobei diejenigen, die größer sind als der kritische Massenschwellenwert, in der Lage sind zu wachsen und Verunreinigungen und Defekte während der Scheibenherstellungsverfahren anzuziehen. Ohne Steuerung kann die Konzentration von solchen Störstellen in einem sehr großen Bereich variieren, und zwar im Bereich zwischen ca. 10⁴ und 10⁷ Stellen/cm². Der gewünschte Bereich liegt zwischen ca. 10⁵ und bis 5x10⁶ Stellen/cm², im allgemeinen zwischen ca. 2x10⁵ und 5x10⁶ Stellen/cm², und kann nach der Methode der vorliegenden Erfindung erhalten werden.

Die Innenstörstellenkonzentrationsreduktionsphase umfaßt das schnelle Erhitzen der Halbleiter-Scheibe von einer Temperatur, die unter 100°C liegt, im allgemeinen ungefähr bei Raumtemperatur, bis zu einer Endtemperatur im Bereich von ca. 900°C bis 1300°C, üblicherweise im Bereich von ca. 1000° C - 1250° C liegt, vorzugsweise im Bereich zwischen 1050° und 1200°C. Die Wärmebehandlungszeit bei erhöhter Temperatur hängt von der Endtemperatur ab, wobei bei niedrigeren Temperaturen im allgemeinen längere Behandlungszeiten erforderlich sind. Die Behandlungszeit muß ausreichend lang sein, um die Auflösung der Anhäufungen von ausscheidbaren Verunreinigungen, die zunächst in der Scheibe vorhanden sind, zu bewirken, so daß die Konzentration der Anhäufungen, die eine kritische Wachstumsmasse aufweisen, unter dem gewünschten Stand liegt, typischerweise unter ca. 10⁶ Stellen/cm², noch typischer unter ca. 10⁵ Stellen/cm² und gelegentlich unter ca. 10⁴ Stellen/cm². Üblicherweise wurde für CZOCHRALSKI-Siliziumscheiben, die im Innern Sauerstoffverunreinigungen aufweisen, das folgende Zeit- und Temperaturverhältnis als geeignet gefunden:

**TABELLE 1**

| Letzte Behandlung Temperatur | Wärmebehandlung Zeit |
|---|---|
| 1000°C | > 20 Sek. |
| 1050°C | > 10 Sek. |
| 1100°C | > 5 Sek. |
| 1150°C | > 2 Sek. |
| 1200°C | > 1 Sek. |
| 1250°C | > 1 Sek.. |

Das Zeit- und Temperaturverhältnis, das in Tabelle 1 dargelegt ist, basiert auf Siliziumscheiben, die eine durchschnittliche Ausgangssauerstoffkonzentration im Bereich von ca. 10 ppma bis ca. 20 ppma, üblicherweise von ca. 12 ppma bis 18 ppma (ASTM F121-83), haben. In einigen Fällen mag es wünschenswert sein, empirisch spezielle Zeit- und Temperaturverhältnisse für besondere Typen von Scheiben, die bekannte Verunreinigungen, Kristallgitterorientierungen, Widerstände und dgl. aufweisen, zu entwickeln. Die Temperatur und die Behandlungszeit, die erforderlich sind, um die Konzentration der Innenstörstellen im gewünschten Bereich zu steuern, können dann als Funktion der gemessenen Ausgangssauerstoffkonzentration der speziellen Scheibe bestimmt werden. Das bedeutet, daß, wenn man die Ausgangssauerstoffkonzentration jeder Scheibe oder Charge der Scheiben, die behandelt werden, mißt (am besten nach ASTM F 121-83), die Scheiben genau behandelt werden können, um die gewünschten Störstellenkonzentrationen zu erlangen.

Schnelles Erhitzen der Scheiben beinhaltet eine Erhitzungsgeschwindigkeit von mindestens ca. 10°C/Sek., vorzugsweise von mindestens ca. 100°C/Sek. oder mehr. Ein derartiges schnelles Erhitzen kann durch Strahlungswärme erfolgen, wobei typischerweise eine Verfahrenseinrichtung, die schnell aufheizt, benutzt wird, und die kommerziell zur Verfügung steht von Lieferanten, wie z.B. PEAK SYSTEMS, INC., FREMONT, Kalifornien, VARIAN ASSOCIATES, Palo Alto, Kalifornien, und AG ASSOCIATES, SUNNYVALE, Kalifornien. Insbesondere wurde ein Hitzeimpuls-Modell, Typ 210T, von AG ASSOCIATES für geeignet befunden, um die Konzentratisonsreduktionsphase nach der Methode gemäß vorliegender Erfindung durchzuführen. Das schnelle Erhitzen wird unter einer inerten oder nichtoxydierenden Atmosphäre durchgeführt, typischerweise Argon oder Stickstoff.

Nach Beendigung der schnellen Erwärmung ist es notwendig, die Scheiben schnell auf eine Temperatur unter ca. 600°C zu kühlen, typischerweise auf einen Wert nahe zur Raumtemperatur. Das Kühlen sollte mit einer Geschwindigkeit von ca. -10°C/Sek., vorzugsweise mit mindestens ca. -50°C/Sek., erfolgen. Wenn man die oben beschriebene Einrichtung für das schnelle Erhitzen benutzt, kann ein solches Kühlen durch einfaches Abdrehen der Wärmestrahlenheizquellen erfolgen.

Die Konzentrationssteigerungssphase der vorliegenden Erfindung umfaßt das Tempern der Scheiben durch Erhitzen auf eine Temperatur im Bereich von ca. 550 - 850°C, üblicherweise im Bereich von zwischen ca. 600 und 750°C für eine Retentionszeit, die ausgesucht wurde, um die Bildung von ausscheidbaren Anhäufungen zu vergrößern, so daß die Konzentration der Innenstörstellen innerhalb des gewünschten Bereichs, von dem obenstehend die Rede ist, liegt. Typischerweise liegt die Behandlungszeit im Bereich zwischen ca. 15 Minuten bis 360 Minuten oder höher, speziell im Bereich von ca. einer bis vier Stunden. Eine solche Behandlung bei niedriger Temperatur wird typischerweise in einem herkömmlichen Kammerofen unter einer inerten oder nicht inerten Atmosphäre durchgeführt. Auf der anderen Seite wäre es auch möglich, die Konzentrationssteigerungsphase durchzuführen, indem man eine Verfahrenseinrichtung für schnelles Erhitzen benutzt, obwohl dies nicht bevorzugt wird.

Normalerweise wird die Temperatur der Scheibe erhöht von Raumtemperatur bis zur Temperungstemperatur im Bereich von ca. 1 bis 20°C pro Minute, üblicherweise im Bereich von ca. 2 bis 10°C pro Minute. Solche Geschwindigkeiten sind jedoch nicht kritisch und ein schnelleres Heraufbringen wäre so lange akzeptabel wie die gesamte Behandlungszeit im gewünschten Temperaturbereich zu der gewünschten Erhöhung der Konzentration der Innenstörstellen führt. Wenn die endgültige Temperatur für das Tempern einmal erreicht ist, wird die Temperatur im allgemeinen gleichmäßig aufrechterhalten, bis die Retentionszeit abgelaufen ist. Es ist erwünscht, die Scheibe zu kühlen. Es gibt jedoch keinen theoretischen Grund, warum die Temperatur nicht während der Behandlung des Temperns bei niedriger Temperatur solange variiert werden könnte, bis am Ende die gewünschte Konzentration der Innenstörstellen erreicht ist.

Wie oben angegeben, ist die Größenordnung der Konzentrationsreduktionsphase und der Konzentrationssteigerungsphase nicht kritisch, und es ist möglich, jede Verfahrensstufe zuerst durchzuführen. Vorzuziehen ist jedoch, daß die Konzentrationssteigerungsphase zuerst durchgeführt wird, um die Konzentration der Innenstörstellen erheblich über das gewünschte Niveau zu erhöhen. Es wurde gefunden, daß die Konzentrationsreduktionsphase eher wiederholbar ist als die Steigerungsphase. Aus diesem Grunde kann man, wenn man die Reduktionsphase zuletzt durchführt, eine genauere Konzentration der Innenstörstellen erhalten.

Nach Behandlung gemäß der vorliegenden Erfindung sind die Halbleiterscheiben für die herkömmlichen Halbleiterherstellungsarbeiten bereit, um die gewünschten integrierten Schaltkreise auf der aktiven Oberfläche der Scheibe zu bilden. Die Scheiben können dann für alle herkömmlichen Mikroelektroniktechnologien, einschließlich Dickfilmhybrid-, Dünnfilmhybrid-Bipolar-Monolith und Metalloxid-Halbleiter (MOS)-Monolith-Technologien verwendet werden. Die Innenstörstellen, die nach dem Verfahren der vorliegenden Erfindung geschaffen werden, dienen dazu, die Verunreinigungen und kristallinen Fehler aus der aktiven Oberfläche der Scheibe bei normaler thermischer Behandlung der Scheibe während der herkömmlichen Verarbeitungsstufen an sich zu ziehen. Auf diesem Wege werden die Verunreinigungen und Defekte von der aktiven Oberfläche beseitigt, um die Ausbeute an Bauelementen auf der Scheibe zu verbessern.

Folgende Beispiele werden zur Veranschaulichung gegeben, stellen jedoch keine Begrenzung dar.

Die Auswirkungen des Verfahrens zum schnellen Erhitzen auf Sauerstoffeinlagerungen werden an p-Typ-Siliziumscheiben mit externen Störstellen gezeigt, die aufgrund einer Polysiliziumschicht auf der Rückseite der Scheibe vorhanden sind. Ein Niederdruckreaktor zur chemischen Dampfabscheidung wurde für die Polysiliziumabscheidung verwendet und im Temperaturbereich von 650° bis 700°C eingesetzt. Dieser Temperaturbereich erhöhte die Bildung von Sauerstoffgruppen in der Masse der Scheibe und infolgedessen die Sauerstoffausscheidung in den nachfolgenden IC-Herstellungsstufen. Eine Anzahl von Siliziumscheiben vom p-Typ, die Sauerstoffkonzentrationen von 15,6 ppma (ASTM F-121-83) und eine Polysiliziumschicht auf der Rückseite aufweisen, wurden schnell von 1100 auf 1200°C innerhalb von Zeiträumen zwischen 10 und 30 Sekunden erhitzt.

Siliziumscheiben vom p-Typ mit Sauerstoffgehalten im Bereich von 15 bis 18 ppma und einer normal chemisch angeätzten Rückseite wurden in einem herkömmlichen Ofen bei Temperaturen im Bereich von 700 bis 800°C für einen Zeitraum von 1 bis 4 Stunden getempert. Diese Bedingungen erhöhten die Dichte der Sauerstoffgruppen in der Masse der Scheiben. Nach dem Tempern bei niedriger Temperatur wurden die Siliziumscheiben einem schnellen Erhitzen für 30 Sekunden bei Temperaturen im Bereich von 1100 bis 1200°C ausgesetzt.

Es wurde ein weiterer Satz von Siliziumscheiben vom p-Typ mit normaler Rückseite zuerst schnell im Temperaturbereich von 1000 bis 1200° C wärmebehandelt. Bei allen Temperaturen betrug die Erhitzungszeit 30 Sekunden. Nach der schnellen Wärmebehandlung wurden die Scheiben in einem herkömmlichen Rohrofen bei 700 bis 800°C getempert. Die Behandlungszeiten bei niedrigen Temperaturen variierten von 2 bis 4 Stunden.

Die schnellen thermischen Behandlungen wurden in einem kommerziell zur Verfügung stehenden System, hergestellt von AG ASSOCIATES (Hitzeimpuls - Modell 210T), durchgeführt. In diesem System wurde die Erhitzungskammer mit zwei Reihen von Wolfram-Halogen-Lampen aufgeheizt. Eine Quarzdiffusionsröhre, die zwischen den beiden Lampenreihen angebracht wurde, enthält die Siliziumscheibe. Während des kurzen Heizzyklus wurde die Röhre kontinuierlich mit Argon gespült. Die Scheibentemperatur wurde durch ein sehr kleines thermoelektrisches Meßgerät, das nahe der Scheibe angebracht war, beobachtet und mit einem Temperatur-Prüfgerät geregelt.

Vor jeder Wärmebehandlung wurde der interstitielle Sauerstoffgehalt der Siliziumscheiben mit einem FTIR-Spektrophotometer (ASTM F-121-38) bestimmt. Der interstitielle Sauerstoffgehalt wurde nach dem zeitlich verlängerten Sauerstoffeinlagerungszyklus, der in Tabelle 2 beschrieben ist, wiederum gemessen. Dieser Wärmezyklus wurde nach dem schnellen Erwärmen und dem bei niedriger Temperatur durchgeführten Tempern verwendet, so daß die Auswirkungen der beiden thermischen Behandlungen auf die Sauerstoffeinlagerung ausgewertet werden konnten. Die Differenz der Sauerstoffkonzentration vor und nach diesem Ausscheidungszyklus ist daher ein Maß für die Dichte der Innenstörstellen in der Masse der Siliziumscheibe und wird nachfolgend als eine "Abnahme des interstitiellen Sauerstoffs" in dieser Anmeldung bezeichnet. Die Sauerstoffausscheidungsdichte in der Masse der Scheibe nach dem Wärmezyklus gemäß Tabelle 2 wurde aus einem gespaltenen Querschnitt bestimmt, der mit einer SECCO-Ätzflüssigkeit für 2,5 Minuten geätzt wurde. Beide Charakterisierungstechniken werden sehr weit verbreitet in der Elektronikindustrie benutzt.

**TABELLE 2**

| Verfahrensbedingungen für den Ausscheidungszyklus | |
|---|---|
| Stoßen: | 15,24 cm (6 Zoll)/Min., 900°C, Sauerstoffumgebung |
| Halten auf einer bestimmten Temperatur für einen längeren Zeitraum: | 900°C, Sauerstoffumgebung, 30 Minuten |
| Ansteigen: | von 900° auf 1025°C, Sauerstoffumgebung |
| Tempern: | 1025°C, Stickstoffumgebung, 8 Stunden |
| Abklingen: | von 1025° auf 1000°C, Stickstoffumgebung |
| Ziehen: | 15,24 cm (6 Zoll)/Min., 1000°C, Stickstoffumgebung |

Die Änderung von interstitiellem Sauerstoff und der Sauerstoffausscheidungsdichte in Siliziumscheiben mit einer Polysiliziumschicht auf der Rückseite wurde bestimmt, wie oben beschrieben, und die Durchschnittswerte werden in Tabelle 3 wiedergegeben. Aus den tabellarisch aufgeführten Ergebnissen kann entnommen werden, daß die Innenstörstellen, die während der Polysiliziumablagerung entstanden sind, entweder teilweise oder ganz nach kurzer schneller Verfahrensstufe unter Hitze aufgelöst werden können. Nach einer Behandlung bei 1200°C wurde die Sauerstoffeinlagerungskinetik in einer Siliziumscheibe mit einer Polysiliziumlage auf der Rückseite nicht mehr unterscheidbar von einer Scheibe mit einer normalen Rückseite. Die Anwendung dieser Erfindung ermöglicht daher die unabhängige Kontrolle der inneren und äußeren Störstellenfähigkeiten der Siliziumscheiben.

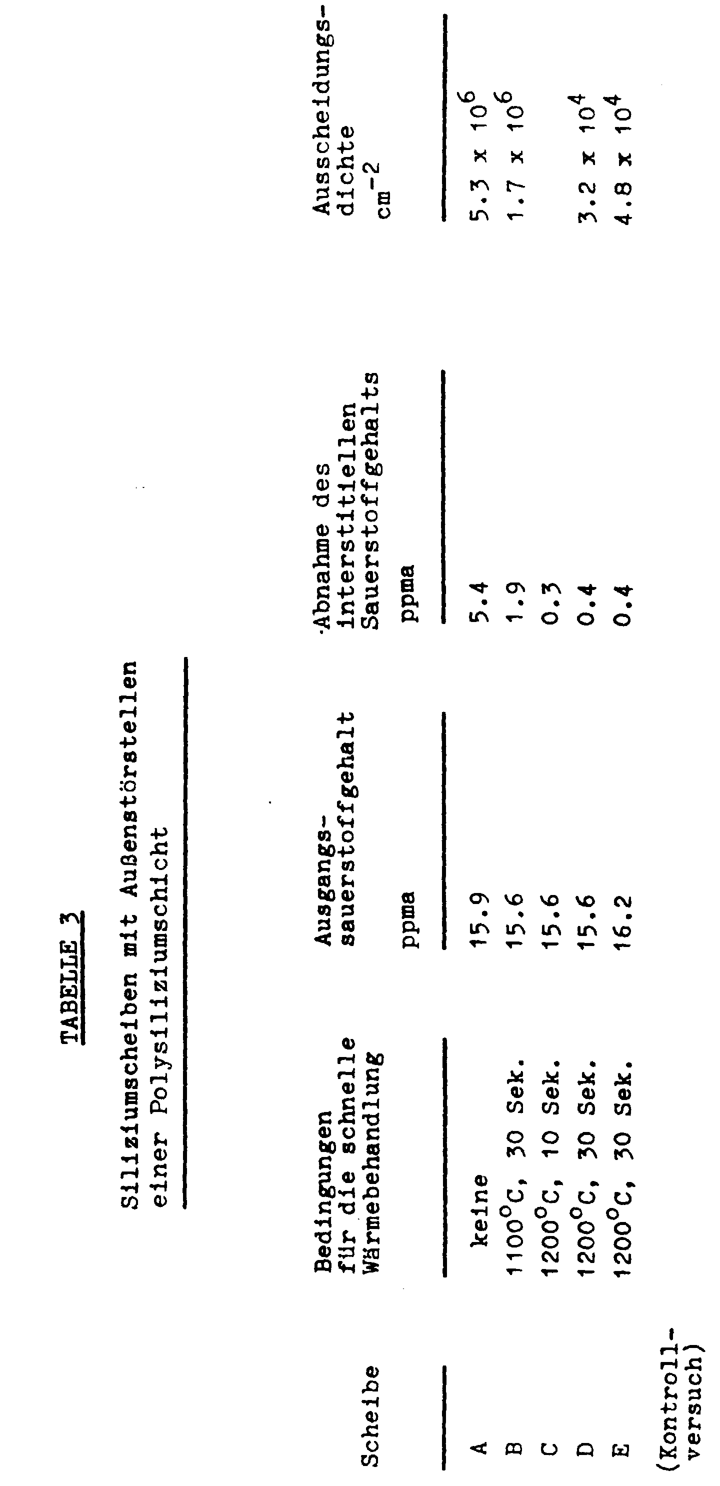

Tabelle 4 fasst den Durchschnitt der Ergebnisse zusammen, die man für normale Siliziumscheiben, die zunächst bei niedrigen Temperaturen vorerhitzt und dann schnell aufgeheizt wurden, erhalten hat. Die Daten zeigen, daß die Menge des ausgeschiedenen Sauerstoffs gesteuert werden kann, indem man die geeigneten Bedingungen für das Vorerhitzen und schnelle Erhitzen wählt. Die Auswirkung des schnellen Erhitzungsverfahrens verringert sich bei höheren Vorheiztemperaturen.

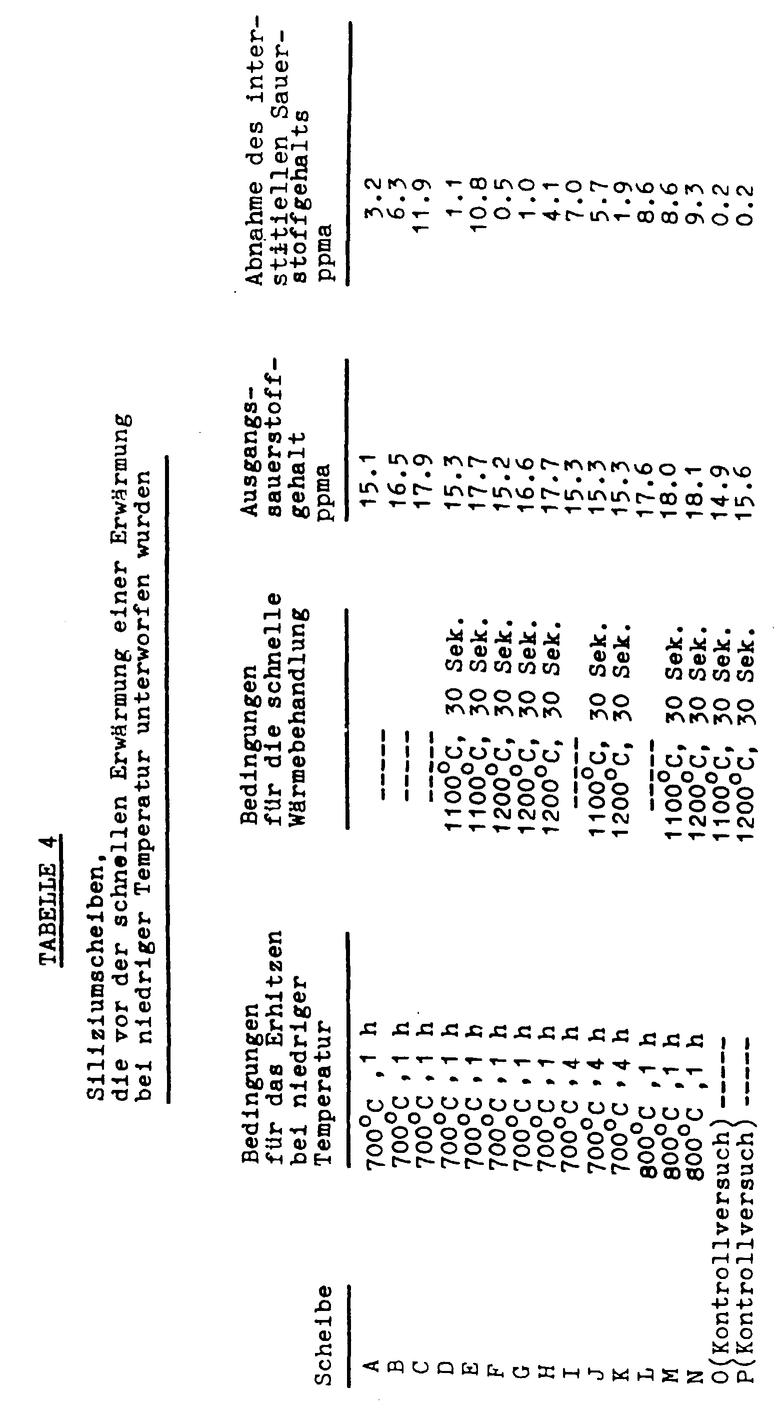

Für Siliziumscheiben, die vor der Behandlung bei niedriger Temperatur schnell erhitzt wurden, wurde die Abnahme des interstitiellen Sauerstoffs und der Ausscheidungsdichte aufgezeichnet, wie oben beschrieben, und die Durchschnittswerte der Ergebnisse sind in Tabelle 5 zusammengefaßt. Die dargelegten Daten zeigen, daß eine kurze schnelle Wärmebehandlung vor einem Erhitzen bei niedriger Temperatur sich auch beträchtlich auf die Ausscheidung des Sauerstoffs auswirkt. Die Menge des ausgeschiedenen Sauerstoffs in einer Siliziumscheibe mindert sich in der Weise wie sich die Temperaturen bei der schnellen Wärmebehandlung erhöhen.

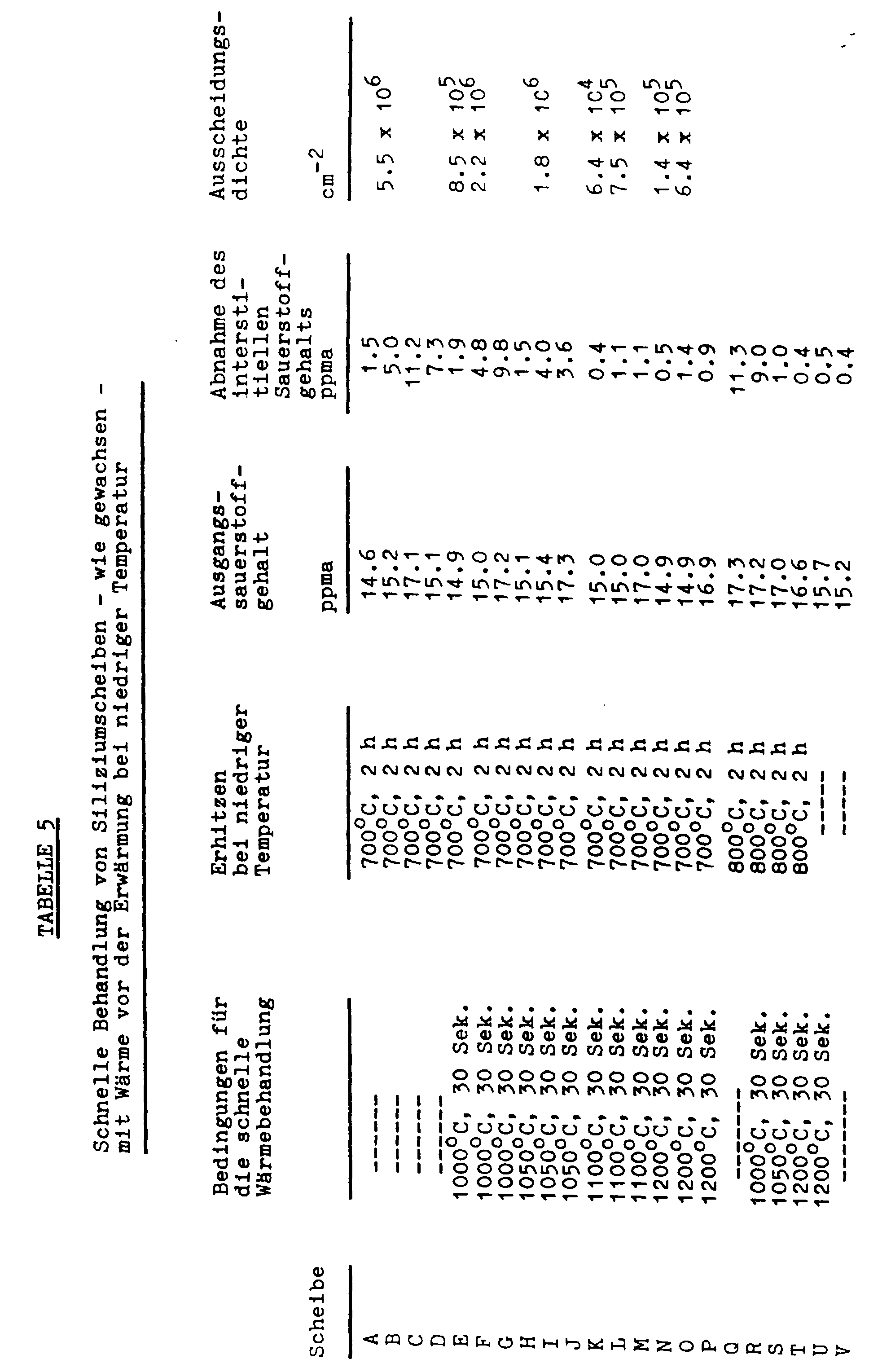

Die Daten der Tabellen 4 und 5 zeigen, daß die Dichte der Innenstörstellen in der Masse einer Siliziumscheibe individuell auf einen gewünschten Stand, unabhängig vom Ausgangssauerstoffgehalt, eingestellt werden kann.

## Patentansprüche

1. Verfahren zur Einstellung der Sauerstoffgruppenkonzentration innerhalb eines Einkristall-Silicium-Halbleitermaterials auf einen gewünschten Optimalwert mit der Durchführung der folgenden Schritte a) und b) in einer vorher bestimmten Reihenfolge:
a) ein schnelles Erhitzen des Einkristall-Silicium-Halbleitermaterials bis zu einer ersten Temperatur im Bereich von 900°C bis 1300°C und Halten bei dieser ersten Temperatur für einen Zeitraum von mindestens einer Sekunde, um die Sauerstoffgruppenkonzentration unter bzw. auf den gewünschten Optimalwert zu reduzieren, und dann ein schnelles Abkühlen des Einkristall-Silicium-Halbleitermaterials bis zu einer Temperatur, die unter 600°C liegt, um die Sauerstoffgruppenkonzentration unter bzw. auf den gewünschten Optimalwert zu fixieren; und
b) ein Erhitzen des Einkristall-Silicium-Halbleitermaterials bis zu einer zweiten Temperatur im Bereich von 600°C bis 850°C und Halten bei dieser zweiten Temperatur für einen Zeitraum von 15 Minuten bis 360 Minuten, um die Sauerstoffgruppenkonzentration auf bzw. über den gewünschten Optimalwert zu erhöhen,
**gekennzeichnet dadurch,** daß
das schnelle Erhitzen und das schnelle Abkühlen im Schritt a) mit einer Geschwindigkeit von mindestens 10°C pro Sekunde stattfindet, und der gewünschte Optimalwert im Bereich von 10⁵ bis 5x10⁶ cm⁻² liegt.

2. Verfahren nach Anspruch 1,
**dadurch gekennzeichnet,** daß Schritt b) zuerst durchgeführt wird, so daß die Sauerstoffgruppenkonzentration über 5x10⁶ cm⁻² erhöht wird, und Schritt a) danach durchgeführt wird, so daß die Sauerstoffgruppenkonzentration auf eine Konzentration im Bereich von 10⁵ bis 5x10⁶ cm⁻² reduziert wird.

3. Verfahren nach einem der Ansprüche 1 oder 2,
**dadurch gekennzeichnet,** daß das Einkristall-Silicium-Halbleitermaterial nach dem Czochralski-Verfahren hergestellt wurde.

4. Verfahren nach einer der Ansprüche 1 oder 2,
**dadurch gekennzeichnet,** daß das Einkristall-Silicium-Halbleitermaterial nach dem Fließzonenverfahren hergestellt wurde.

5. Verfahren nach einem der vorhergehenden Ansprüche,
**dadurch gekennzeichnet,** daß die Geschwindigkeit für das schnelle Erhitzen im Schritt a) mindestens 25°C pro Sekunde beträgt.

## Claims

1. Process for adjusting the oxygen group concentration within a single crystal silicon semiconductor material to a desired optimum value by carrying out the following steps a) and b) in a predetermined sequence:
a) rapid heating of the single crystal silicon semiconductor material to an initial temperature in the region of 900°C to 1300°C and maintaining it at this first temperature for a period of at least one second in order to reduce the oxygen group concentration to or below the desired optimum value, followed by rapid cooling of the single crystal silicon semiconductor material to a temperature below 600°C in order to fix the oxygen group concentration at or below the desired optimum value; and
b) heating of the single crystal silicon semiconductor material to a second temperature in the region of 600°C to 850°C and maintaining it at this second temperature for a period of 15 minutes to 360 minutes in order to increase the oxygen group concentration to or above the desired optimum value,
characterised in that
the rapid heating and the rapid cooling in step a) takes place at a rate of at least 10°C per second and the desired optimum value is in the region of 10⁵ to 5x10⁶ cm⁻².

2. Process according to claim 1,
characterised in that step b) is carried out first such that the oxygen group concentration is increased to above 5x10⁶ cm⁻² and step a) is subsequently carried out such that the oxygen group concentration is reduced to a concentration in the region of 10⁵ to 5x10⁶ cm⁻².

3. Process according to one of claims 1 or 2, characterised in that the single crystal silicon semiconductor material was produced according to the Czochralski method.

4. Process according to one of claims 1 or 2, characterised in that the single crystal silicon semiconductor material was produced according to the fluidised zone method.

5. Process according to one of the preceding claims, characterised in that the rate of rapid heating in step a) is at least 25°C per second.

## Revendications

1. Procédé permettant de fixer à une valeur optimale souhaitée la concentration en fonctions oxygène à l'intérieur d'un matériau semi-conducteur en silicium monocristallin, en effectuant les étapes a) et b) suivantes dans un ordre déterminé au préalable :
a) échauffement rapide du matériau semi-conducteur en silicium monocristallin jusqu'à une première température comprise entre 900 et 1 300 °C et maintien à cette première température pendant une durée d'au moins une seconde afin d'abaisser la concentration en fonctions oxygène à - ou en dessous de - la valeur optimale souhaitée, puis refroidissement rapide du matériau semi-conducteur en silicium monocristallin jusqu'à une température inférieure à 600 °C, pour fixer la concentration en fonctions oxygène à - ou en dessous de - la valeur optimale souhaitée ;
et
b) échauffement du matériau semi-conducteur en silicium monocristallin jusqu'à une seconde température comprise entre 600 et 850 °C et maintien à cette seconde température pendant une durée comprise entre 15 et 360 minutes afin d'élever la concentration en fonctions oxygène à - ou au-dessus de - la valeur optimale souhaitée,
caractérisé en ce que,
l'échauffement rapide et le refroidissement rapide de l'étape a) s'effectuent à une vitesse d'au moins 10 °C par seconde et en ce que la valeur optimale souhaitée se situe dans la plage de 10⁵ à 5 × 10⁶ cm⁻².

2. Procédé selon la revendication 1,
caractérisé en ce que l'étape b) est effectuée en premier, de telle sorte que la concentration en fonctions oxygène soit élevée à une valeur supérieure à 5 × 10⁶ cm⁻², l'étape a) étant effectuée ensuite, de telle sorte que la concentration en fonctions oxygène soit réduite à une valeur qui se situe dans la plage de 10⁵ à 5 × 10⁶ cm⁻².

3. Procédé selon l'une ou l'autre des revendications 1 et 2, caractérisé en ce que le matériau semi-conducteur en silicium monocristallin a été obtenu par le procédé Czochralski.

4. Procédé selon l'une ou l'autre des revendications 1 et 2, caractérisé en ce que le matériau semi-conducteur en silicium monocristallin a été obtenu par le procédé de tirage par zone flottante.

5. Procédé selon l'une quelconque des revendications précédentes, caractérisé en ce que l'échauffement rapide de l'étape a) s'effectue à une vitesse d'au moins 25 °C par seconde.
